# EUROPEAN PATENT APPLICATION

(11) **EP 3 124 646 A1**
(43) Date of publication of application: **01.02.2017**
(21) Application number: 15306241.9
(22) Date of filing: 30.07.2015
(51) Int. Cl.: C23C 14/24, C23C 14/50, C23C 14/12, G02B 1/10, C03C 17/00, C23C 16/448, C23C 16/455

(54) **MACHINE FOR COATING AN OPTICAL ARTICLE AND ASSEMBLY AND METHOD INCLUDING OR CARRYING OUT THIS MACHINE**

(71) Applicant: ESSILOR INTERNATIONAL (Compagnie Générale d'Optique), 94220 Charenton-le-Pont (FR)
(72) Inventor: GLACET, Arnaud, Dallas, TX Texas TX75234 (US); FOURNAND, Gérald, Dallas, TX Texas TX75234 (US)
(74) Representative: Santarelli

(57) **Abstract**

The invention concerns a machine for coating an optical article (28), comprising a chamber (8) configured to receive said article and an evaporation device (10) configured to carry out a vacuum treatment of a coating composition for depositing it onto said article, said device comprising a crucible (30) from which the composition in evaporated state leaves the device; the machine comprising a hollow housing (40) surrounding a housing space (41) which is above and open towards the crucible, and an article holder (42), the hollow housing and the article holder being configured for locating in the housing space the article held by the holder. The invention concerns an assembly comprising such machine and an optical article held by the holder; and a method for coating an optical article, comprising the steps of providing such machine, holding the article with the holder and carrying out a coating composition depositing cycle.

## Description

### FIELD OF THE INVENTION

The invention relates to machines for coating optical articles such as ophthalmic lenses, and in particular to machines having a vacuum chamber and an evaporation device configured to carry out in the interior space of the vacuum chamber a vacuum evaporation treatment of a coating composition for depositing the coating composition onto the optical articles.

### BACKGROUND ART

It is well known that optical articles comprise an optical substrate having the required geometrical features, for instance for correcting the vision of the wearer if the optical article is a spectacle lens.

The optical substrate requires the addition of coatings, for instance an anti-abrasive coating to increase the abrasion resistance of the lens, an antireflective coating to decrease the reflexion of light and an anti-soiling coating applied over the anti-reflective coating.

Some of those coatings are made from liquid compositions which have to be deposited on the optical substrate. The above-mentioned machines are able to carry out the deposition through vacuum evaporation of the liquid composition. The above mentioned machines are specifically adapted to carry out the deposition of an anti-soiling coating or an anti-fogging coating or other topcoats as a most external layer on the optical substrate.

Such machines in which the coating composition in evaporated state leaves the evaporation device from a crucible are already known, for instance from French patent application 2 775 298 corresponding to United States Patent US 6,375,747 or from European Patent Application EP 2 548 991.

### SUMMARY OF THE INVENTION

The invention is directed to such a machine which is efficient for coating a small number of optical articles, for instance two or even one article, while remaining simple, economic and convenient.

To this end, the invention proposes a machine for coating an optical article, comprising:
- a vacuum chamber having an interior space configured to receive said optical article; and
- an evaporation device configured to carry out a vacuum evaporation treatment of a coating composition for depositing the coating composition onto said optical article in said interior space, said evaporation device comprising in the interior space a crucible from which the coating composition in evaporated state leaves the evaporation device;
   characterized in that the machine comprises in the interior space a hollow housing surrounding a housing space which is at least partially above the crucible and open towards the crucible, and the machine comprises in the housing space an article holder, the hollow housing and the article holder being configured for locating in the housing space the optical article held by the article holder.

Since the housing space is at least partially above the crucible and is open towards the crucible, and since the coating composition in evaporated state leaves the crucible mostly upwards, the coating composition in evaporated state leaving the crucible passes through the housing space before going to the remainder of the interior space of the vacuum chamber.

The concentration of the coating composition in evaporated state is thus greater in the housing space than in the remainder of the interior space and also greater than in the interior space of the vacuum chamber of the conventional machines where the coating composition goes directly in all the interior space.

Since the hollow housing and the article holder are configured for locating in the housing space the optical article held by the article holder, the optical article is located in a space where the concentration of coating composition is high and therefore the optical article is coated very efficiently by the coating composition.

In addition, for a given thickness of material deposited on the optical article, there is less coating composition deposited on the inner surfaces of the vacuum chamber and therefore less fouling of the vacuum chamber and less losses of the coating composition. Indeed, less coating composition in the crucible is needed to be evaporated in order to coat the optical article as compared to other machines without hollow housing as described above.

The machine according to the invention does not have a miniaturized vacuum chamber. Instead, an existing (large or medium) vacuum chamber is used with the hollow housing appropriately positioned in the interior space, what is simple and economic and convenient to carry out.

According to advantageous features:
- the vertical distance between the crucible and the article holder is between 2 and 20 times smaller than the height of the interior space; and/or
- the vertical distance between the crucible and the article holder is between 10 and 25 cm.

According to advantageous features:
- the hollow housing is dome-shaped;
- the hollow housing is duct-shaped with at least one inlet opening and at least one outlet opening, the inlet opening facing the crucible, the article holder being located between the inlet opening and the outlet opening;
- the at least one inlet opening has an apparent section and is positioned so that the apparent section covers a part of an evaporation cone formed by the coating composition in evaporated state when leaving the crucible; for instance, the apparent section may cover more than the half of the evaporation cone, preferably between three quarts and all of the evaporation cone.
- the outlet opening faces away from the crucible;
- the hollow housing has a plurality of said outlet openings;
- the hollow housing comprises two main surfaces facing each other and the article holder is configured for locating the optical article held by the article holder with each main face of the optical article facing a respective one of said main surfaces;
- the article holder is configured for locating the optical article held by the article holder at mid-distance between the two main surfaces;
- the main surfaces are substantially parallel one another;
- one of said main surfaces belongs to a removable wall;
- the hollow housing comprises two transverse surfaces facing each other and each extending from one of the main surfaces to the other of the main surfaces, the housing space being delimited laterally by the main surfaces and by the transverse surfaces;
- the transverse surfaces are arranged as mirror images of each other;
- the housing space has a divergent portion between an inlet opening and an optical article receiving portion;
- the machine comprises in the housing space a flow separator and the hollow housing, the article holder and the flow separator are configured for receiving two lenses in respective predetermined locations in the housing space with the flow separator disposed between the respective predetermined locations;
- the flow separator extends below the respective predetermined locations;
- the article holder and the flow separator are formed by a protuberance extending transversely between the main surfaces;
- the housing space is configured for only receiving a small number of optical articles to be coated, for instance two or even one article; and preferably there is no place for receiving something other as the optical article(s);
- the housing space has a volume between 2 and 20 times smaller than the volume of the interior space of the vacuum chamber;
- the housing space has a volume between 300 and 600 cm³; and/or
- the article holder is configured for holding a pair of glasses comprising a frame and two lenses.

The invention is also directed, in a second aspect, to an assembly comprising a machine as disclosed above and an optical article held by the article holder of said machine.

Preferably, the optical article is a pair of glasses comprising a frame and two lenses.

The invention is also directed, in a third aspect, to a method for coating an optical article comprising the step of providing a machine as described above, the step of holding the optical article with the article holder in the housing space and the step of carrying out with said machine a coating composition depositing cycle.

### BRIEF DESCRIPTION OF THE DRAWINGS

The description of the invention now continues with a detailed description of preferred embodiments given hereinafter by way of non-limiting example and with reference to the appended drawings. In these drawings:
- Figure 1 is a schematic view of a system for coating according to the invention;
- Figures 2 and 3 are partially schematic views of the system showing in particular a vacuum chamber, an optical article to be coated, a crucible containing a coating composition, a hollow housing and an article holder which are configured for locating in a housing space the optical article held by the article holder, and a door of the chamber being respectively open and closed;
- Figure 4 represents in more detail the housing space, the hollow housing and the article holder, which are shown schematically and partially in perspective;
- Figure 5 is a similar view as Figure 4, showing the way of the coating composition in evaporated state in the housing space; and

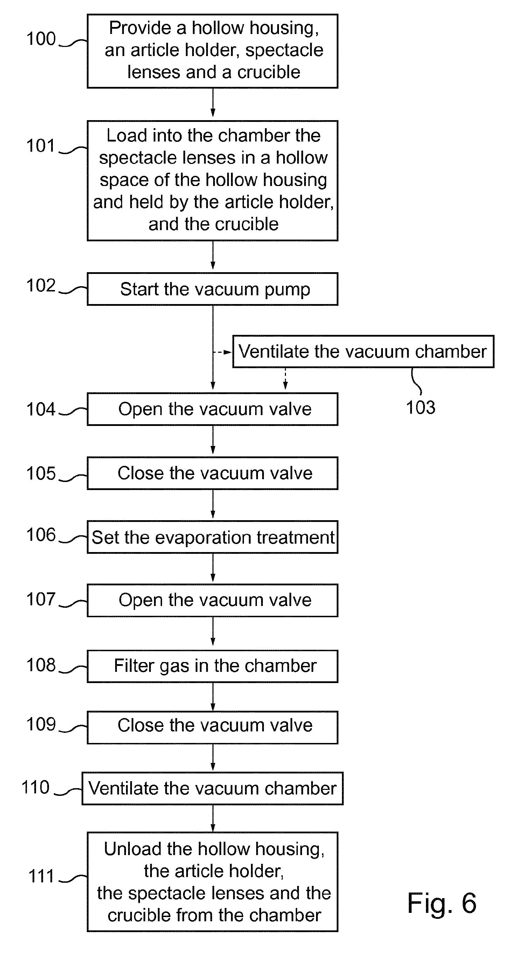

- Figure 6 is a block diagram illustrating steps for using the system for coating the optical article according to an embodiment.

### DETAILED DESCRIPTION OF PREFERED EMBODIMENTS

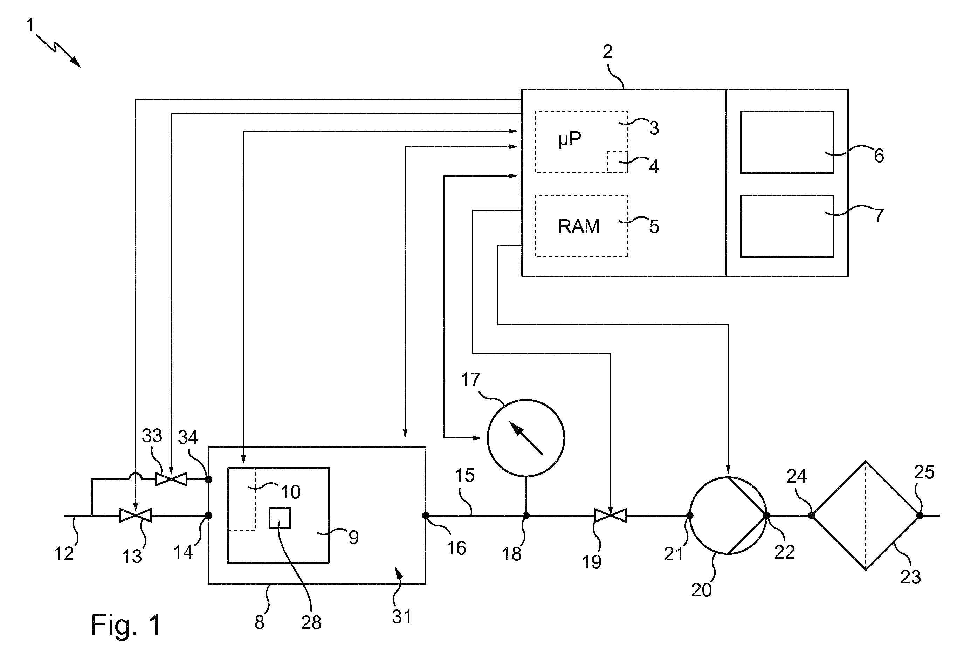

Figure 1 shows a coating treatment machine 1 for coating an optical article 28 formed here by a spectacle lenses.

The machine 1 comprises a vacuum chamber 8, an evaporation device 10, an inlet circuit 12, an outlet circuit 15, a vacuum pump 20 and a control unit 2.

The vacuum chamber 8 comprises an interior space 31 configured to receive the spectacle lenses 28.

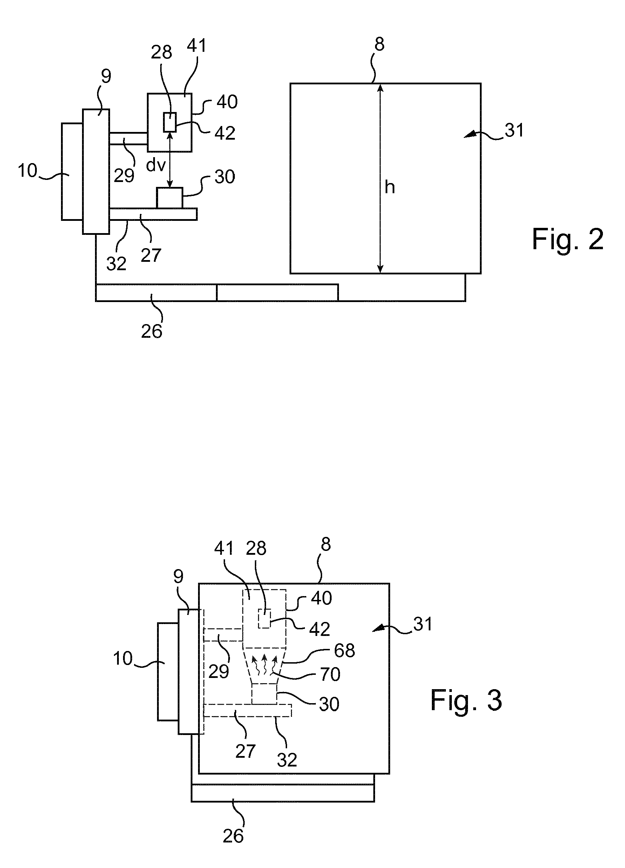

The vacuum chamber 8 further comprises a door 9 which is removable (see description of Figures 2 and 3 below).

The evaporation device 10 is placed in the vacuum chamber 8 (i.e. mounted on the door 9 of the vacuum chamber 8) (see below).

The vacuum chamber 8 further comprises a first inlet port 14 and a second inlet port 34 both connected to the inlet circuit 12.

The machine 1 further comprises a gas inlet valve 13 mounted on the inlet circuit 12 and an inlet valve 33 which is also mounted on the inlet circuit 12, parallel to the inlet valve 13.

The vacuum chamber 8 further comprises an outlet port 16 connected to the outlet circuit 15.

The vacuum pump 20 is connected to the outlet circuit 15 via an admission port 21 of the vacuum pump 20 and via an exit port 22 of the vacuum pump 20 so that the outlet circuit 15 passes through the vacuum pump 20.

The machine 1 further comprises a pressure sensor 17 which is connected to the outlet circuit 15 via a branching point 18.

The machine 1 further comprises a vacuum valve 19 which is mounted on the outlet circuit 15, between the branching point 18 and the admission port 21 of the vacuum pump 20.

The machine 1 further comprises a filtering device 23 here formed by a gas filter.

The filtering device 23 is connected to the outlet circuit 15 via an entrance port 24 and via an exhaust port 25 of the filtering device 23.

The exhaust port 25 is linked to the atmosphere.

The filtering device 23 is here mounted at the end of the outlet circuit 15, after the vacuum pump 20.

The control unit 2 comprises a data processing system comprising a microprocessor 3 having a memory 4, in particular non volatile, allowing a software application, in other words a computer program, to be loaded and stored therein, and which allows the method for coating the spectacle lenses 28 to be carried out when it is executed in the microprocessor 3.

The non volatile memory is for instance a read only memory.

The data processing system further comprises a memory 5, for instance volatile, allowing storage of data during the execution of the software and the implementation of the method.

The volatile memory 5 is for instance a random access memory or an electrically erasable programmable read only memory.

The control unit 2 further comprises a communication interface configured to communicate with the data processing system.

The communication interface is here formed by a graphic interface 6 and a keyboard 7.

The control unit 2 is configured to control and exchange data with the gas inlet valves 13 and 33, the evaporation device 10, the pressure sensor 17, the vacuum valve 19 and the vacuum pump 20.

The control unit 2 is configured to control the evaporation device 10 for carrying out with the machine 1 a coating composition depositing cycle.

Figures 2 and 3 show in detail the vacuum chamber 8 and its removable door 9 respectively in an open state and in a closed state.

The vacuum chamber 8 comprises a displacement member 26 configured for sliding the door 9 between its open and closed states.

The machine 1 further comprises a first support 27 mounted on the interior face of the door 9. The first support 27 may be movable, vertically and/or longitudinally.

The first support 27 is configured to receive a crucible 30 which is configured to be filed or imbibed with a predetermined coating liquid composition.

The first support 27 forms a part of the evaporation device 10.

The evaporation device 10 comprises a heating module 32 mounted on the interior face of the door 9, connected both to the first support 27 and to a power supply source (not shown) in order to heat the liquid coating composition via the crucible 30 and via the first support 27.

The machine 1 further comprises a second support 29 which is here also mounted on the interior face of the door 9. The second support 29 may be movable, vertically and/or longitudinally.

The second support 27 is configured to receive the spectacle lenses 28 mounted on the spectacle frame (see in more detail below).

The machine 1 further comprises a hollow housing 40 surrounding a housing space 41 which is configured to be disposed above the crucible 30 and to open towards the crucible 30.

The second support 27 is also configured to receive the hollow housing 40. The second support 27 may comprise at least one arm (not represented) configured to bear the hollow housing. The arm may be adjustable in order to place the hollow housing in a determined position relative to the crucible.

The machine 1 further comprises an article holder 42 in the housing space 41 and the second support 27 is also configured to receive the article holder 42.

More precisely, the hollow housing 40 and the article holder 42 are configured for locating in the housing space 41 the spectacle lenses 28 held by the article holder 42.

The open state of the door 9 enables loading of the crucible 30 imbibed with the liquid coating composition on the first support 27, and the hollow housing 40 together with the article holder 42 and the spectacle lenses 28 on the second support 29.

The hollow housing 40, which is dome-shaped, is mounted on the second support 29 so that the vertical distance dv between the crucible 30 and the article holder 42 is between 2 and 20 times smaller than the height h of the interior space 31 of the chamber.

For instance, the vertical distance dv between the crucible 30 and the article holder 42 is between 10 mm and 200 mm, preferably between 30 mm and 100 mm.

Since the housing space 41 is above the crucible 30 and is open towards the crucible 30, and since the liquid coating composition in evaporated state leaves the crucible 30 mostly upwards, the coating composition in evaporated state leaving the crucible 30 passes through the housing space 41 before going to the remainder of the interior space 31 of the vacuum chamber 8.

The inlet opening of the housing space is remote to and above the crucible, for instance at 10 mm therefrom.

The way of the liquid coating composition in evaporated state leaving the crucible 30 is illustrated by the arrows 70 in Figure 3.

The arrows 70 are represented in evaporation cone 80 formed by the coating composition in evaporated state when leaving the crucible.

The evaporation cone 80 extends between the crucible 30 and the hollow housing 40 and diverges towards this latter.

The concentration of the coating composition in evaporated state is thus greater in the housing space 41 than in the remainder of the interior space 31 and also greater than in the interior space of the vacuum chamber of the conventional machines where the coating composition goes directly in all the interior space.

Since the hollow housing 40 and the article holder 42 are configured for locating in the housing space 41 the spectacle lenses 28 held by the article holder 42, the spectacle lenses 28 are located in a space where the concentration of evaporated coating composition is high and therefore the spectacle lenses 28 are coated very efficiently by the coating composition.

In addition, for a given thickness of material deposited on the spectacle lenses 28, there is less coating composition deposited on the inner surfaces of the vacuum chamber 8 and therefore less fouling of the vacuum chamber 8 and less losses of the coating composition.

The machine 1 does not have a miniaturized vacuum chamber 8. Instead, an existing (large or medium) vacuum chamber 8 is used with the hollow housing 40 appropriately positioned in the interior space 31.

When the crucible 30 and the hollow housing 40 together with the article holder 42 and the spectacle lenses 28 are received on their respective supports 27, 29, the door 9 can be moved from its open state to its closed state as shown on Figure 3.

In this closed state of the door 9, the crucible 30 imbibed with the liquid coating composition and the hollow housing 40 together with the article holder 42 and the spectacle lenses 28 are all in the vacuum chamber 8.

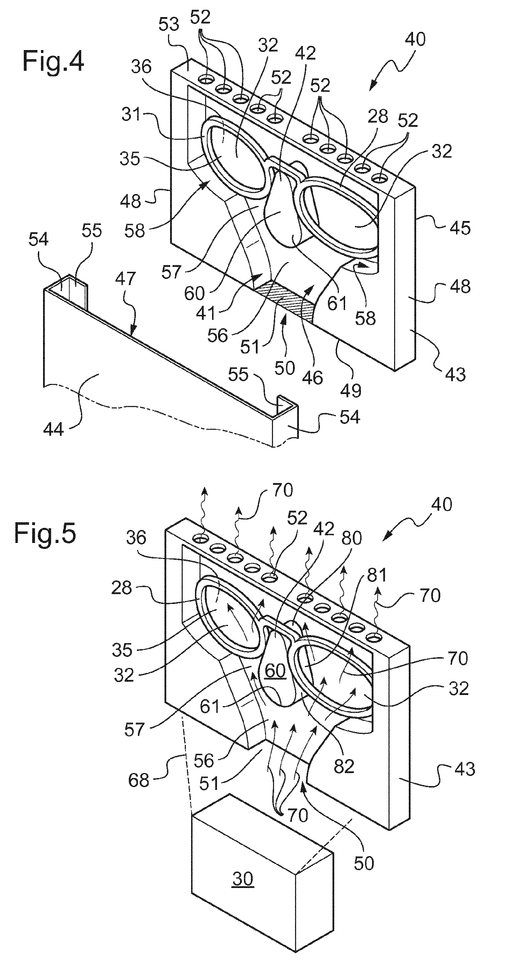

We will now describe in reference to Figures 4 and 5 an embodiment of the hollow housing 40, the housing space 41, the article holder 42 and the spectacle lenses 28 located in the housing space 41.

The spectacles lenses 28 are here formed by a pair of glasses comprising a frame 31 and two lenses 32.

Each lens 32 has a first surface 35 and a second surface 36 which is opposite to the first surface 35. The first surface 35 is for instance a concave surface of whereas the second surface 36 is for instance a convex surface.

The hollow housing 40 comprises a body 43 in which are formed the housing space 41, and a removable wall 44 which is configured to be fastened to the body 43 during the coating deposition cycle and which is further configured to be removed from the body 43 for the introduction of the spectacle lenses 28 in the housing space 41.

The removable wall 44 comprises two lateral flanges 54 extending on the opposite sides of the removable wall 44, and two fastening edges 55 which each protrude from a respective lateral flange 54 and which face the removable wall 44.

It is to be noted that other means are available to provide the wall 44 while being able to access the inside of the hollow housing in order to arrange the optical article to be coated on the article holder 42.

The body 43 comprises a main wall 45, two transverse walls 48 facing each other and each extending from the main wall 45, a lower wall 49 extending from the main wall 45 and joining both transverse walls 48, and an upper wall 53 facing the lower wall 59, extending from the main wall 45 and joining both transverse walls 48.

The main wall 45 of the body 43 and the removable wall 44 form two main surfaces 46 and 47 of the hollow housing 40 which face each other and which are substantially parallel one another.

The two transverse walls 48 and 49 define two transverse surfaces 58 facing each other and each extending from one the main surface 46 to the other main surface 47 in the fastened position of the removable wall 44.

The transverse surfaces 58 are arranged as mirror images of each other.

The removable wall 44 is configured to be fastened on the body 43 thanks to the cooperation between the two lateral flanges 54 and the two lateral walls 48 and between the two fastening edges 55 and the main wall 45.

The hollow housing 40 is duct-shaped and comprises here one (a single) inlet opening 50 formed in the lower wall 49 of the body 43 and configured to face the crucible 30.

The hollow housing 40 further comprises a plurality of outlet openings 52 formed in the upper wall 53, opposite to the inlet opening 50, and which face away from the crucible 30.

The inlet opening 50 has an apparent section 51 (or an open section which is schematically represented with hatching in Figure 4) and is positioned so that the apparent section 51 covers at least a part of the evaporation cone 68 formed by the coating composition in evaporated state when leaving the crucible 30 (Figure 5).

Preferentially the apparent section 51 covers at least the half of the evaporation cone 68, while in some embodiments, the apparent section covers between the three-quarters and the entire evaporation cone 68.

The machine comprises 1 a protuberance 60 provided in the body 43 and extending transversely between the main surfaces 46 and 47 in the housing space 41.

The protuberance 60 is configured to receive and maintain the optical article, for example a frame of spectacles, comprising two spectacle lenses.

The protuberance 60 shown here is drop-shaped and comprises a top wall 80, two slope lateral walls 81 joining the top wall 82, and a curved bottom wall 83 opposite to the top wall 81 and joining the two slope lateral walls 82 (Figure 5).

The top wall 80 and the two slope lateral walls 81 form here the article holder 42; while the curved bottom wall 82 forms a flow separator 61 in the housing space 41.

The hollow housing 41, the article holder 42 and the flow separator 61 are configured for receiving the two lenses 32 in respective predetermined locations in the housing space 41 with the flow separator 61 and more generally the protuberance 60 disposed between the respective predetermined locations.

The article holder 42 is located between the inlet opening 50 and the plurality of outlet openings 52.

The article holder 42 is configured for holding the pair of glasses comprising the frame 31 and the two lenses 32 and for locating the lenses 32 at mid-distance between the two main surfaces 46 and 47 of the hollow housing 40.

The article holder 42 is configured for locating the spectacle lenses 28 held by the article holder 42 with the first and second surfaces 35 and 36 of each of the lenses 32 facing a respective one of main surfaces 46 and 47 of the hollow housing 40.

The flow separator 61 further extends below the respective predetermined locations.

The housing space 41 is delimited laterally by the main surfaces 46 and 47 and by the transverse surfaces 58, and is further delimited on top by the upper wall 53 and on the bottom by the lower wall 49.

The housing space 41 has an optical article receiving portion 57 formed by the respective predetermined locations and a divergent portion 56 between the inlet opening 50 and the optical article receiving portion 57.

More generally, the housing space 41 is configured for only receiving a small number of optical articles to be coated, for instance two or even one article; and preferably there is no place for receiving something other as the optical article(s).

For instance, the housing space 41 has a volume between 2 and 20 times smaller than the volume of the interior space 31 of the vacuum chamber 8; and preferably the housing space 41 has a volume between 300 and 600 cm³.

The hollow housing and the article holder are here formed as a single piece made for instance from plastic material.

Figure 5 shows the path for the coating composition in evaporated state, from the crucible 30 in the evaporation cone 68 to the remainder of the interior space 31 of the vacuum chamber 8, by passing through the hollow space 41.

The coating composition in evaporated state follows the arrows 70. More precisely, the coating composition in evaporated state enters in the housing space 41 by the apparent section 51 of the inlet opening 50, next successively flows along the divergent portion 56 and along the optical article receiving portion 57, where the coating composition in evaporated state is separated by the flow separator 61 and reaches both the first and second surfaces 35 and 36 of the two lenses 32 disposed in the respective predetermined locations.

Such flow is enabled by the geometry of the hollow housing and in particular by the cooperation of the flow separator 61, the transverses surfaces 58 and both the main wall 45 and the removable wall 44.

In particular, in the present embodiment, the coating composition in evaporated state is directed toward both sides of the optical lenses. In an alternative embodiment, the flow separator 61 and/or one of the walls 45 or 44, may be arranged to have a flow regulator that directs the coating composition in evaporated state mainly toward one side of each optical lens.

Next, the coating composition in evaporated state flows out from the housing space 41 by the plurality of outlet openings 52 and enters in the remainder of the interior space 31 of the vacuum chamber 8.

We will now describe in detail the method for using the machine 1 in order to coat the spectacle lenses 28 with a predetermined liquid coating composition.

More generally, the method comprises the step 100 of providing the machine 1 as described above, including the hollow housing 40 and the article holder 42, spectacle lenses 28 and the crucible 30 previously filed or imbibed with a predetermined liquid coating composition to deposit.

The method comprises the step 101 of holding the spectacle lenses 28 with the article holder 42 in the housing space 41, thanks to the protuberance 60, and of loading the hollow housing 40 and the crucible 30 in the vacuum chamber 8.

For that purpose, the removable wall 44 of the hollow housing 40 is removed from the body 43, allowing a free access to the housing space 41.

The spectacle lenses 28 are located in the housing space 41, each lens 32 being housed in the respective predetermined location, from either sides of the protuberance 60. The spectacle lenses 28 are thus disposed between the inlet opening 50 and the outlet openings 52. The removable wall 44 is then mounted and preferably fastened on the body 43.

Next, the user opens the door 9 of the vacuum chamber 8 and loads the crucible 30 and the hollow housing 40 respectively on the first support 27 and on the second support 29.

The user closes the door 9 of the vacuum chamber 8.

Next, the user starts the treatment program for coating the spectacle lenses 28 via the keyboard 7 and the graphic interface 6.

The control unit 2 then takes over the coating treatment.

The vacuum pump 20 is started at step 102 and the vacuum valve 19 is opened at step 104 in order to connect (a flow connection) the vacuum pump 20 to the vacuum chamber 8 for evacuating the interior space 31 of the vacuum chamber 8 via the outlet circuit 15. The vacuum pump 20 is thus able to suck the gases from the vacuum chamber 8.

The control unit 2 is configured to control the pressure (he waits and takes pressure measurements) in the vacuum chamber 8 via the pressure sensor 17 until the vacuum chamber pressure reaches a predetermined pressure value, for instance about 50 mbar.

Optionally, in step 103, the gas inlet valve 13 is opened in order to allow gas to enter in the vacuum chamber 8 via the inlet circuit 12 to have a stable pressure in the vacuum chamber 8. The gas is here atmospheric air. The inlet valve 13 is then closed to end the venting step 103.

The venting step 103 can be carried out before or after the step 104 of opening the vacuum valve 19.

The vacuum valve 19 is then closed at step 105 in order to disconnect (a flow interruption) the vacuum pump 20 from the vacuum chamber 8. The vacuum pump 20 is thus able not to suck the gases from the vacuum chamber 8.

The heating module 32 of the evaporation device 10 is then setting at step 106 for a predetermined time at a predetermined current in order to reach a predetermined temperature of the heating module 32.

The predetermined time is for instance about 30 to 50 s and the predetermined heating temperature is about 350 °C. Heat time and temperature are dependent on evaporation pressure and precursor used.

The heat of the heating module 32 is at least partially transferred to the crucible 30 and thus to the coating liquid composition.

Then, the heating step is stopped and the evaporation treatment continues (step 106) for a predetermined time which is for instance equal to 60 to 180 s.

During the step of evaporating, as described above, the coating composition is evaporated and leaves the crucible 30 mostly upwards, in the evaporation cone 68, so that the coating composition in evaporated state:
- enters in the housing space 41 by the apparent section 51 of the inlet opening 50;
- successively flows along the divergent portion 56 and along the optical article receiving portion 57, where the coating composition in evaporated state is separated by the flow separator 61 and reaches both the first and second surfaces 35 and 36 of the two lenses 32 in order to coat them; and
- flows out from the housing space 41 by the plurality of outlet openings 52 and enters in the remainder of the interior space 31 of the vacuum chamber 8.

Thus, the vapour is first deposited on the spectacle lenses 28 and next the remainder of the vapour reaches the remainder of the interior space 31 of the vacuum chamber 8.

Next, the vacuum valve 19 is opened at step 107 in order to reconnect (a flow connection) the vacuum pump 20 to the vacuum chamber 8 for evacuating the vacuum chamber 8, and in particular for evacuating the gases emitted during the vacuum evaporation treatment because such gases might be toxic. The vacuum pump 20 is thus able to suck the gases from the vacuum chamber 8.

The gases are sent from the vacuum pump 20 to the filtering device 23 where the gases are filtered at step 108.

The filtering step 108 is carried out for a predetermined time, for instance about 120 s.

The vacuum valve 19 is then closed at step 109 so that the vacuum pump 20 is disconnected (a flow interruption) from the vacuum chamber 8. The vacuum pump 20 is thus able not to suck the gases from the vacuum chamber 8.

A venting step 110 is carried out for equilibrating the chamber pressure with atmospheric pressure. The venting step 110 is identical to the venting step 103.

The gas inlet valve 33 is opened for a predetermined time, for instance 60 s, in order to vent the vacuum chamber 8 and the gas inlet valve 33 is then closed.

The coating treatment is thus finished and the user opens the door 9 of the vacuum chamber 8.

There is no risk because all the toxic gases have been filtered and the air during the treatment has been exhausted.

At step 111, the user unloads the hollow housing 40 including the spectacle lenses 28 which are coated with the predetermined coating composition, and the crucible 30. The liquid coating composition has been consumed and the crucible 30 may be a disposable product.

The user may wash the spectacle lenses 28 with a cleaning solution, such as IPA ("isopropyl alcohol or isopropanol").

The predetermined coating composition might be a top coat.

Such a topcoat might be a polymeric layer that can be deposited in order to improve the deposition performances of a topcoat layer. In particular when one desires to deposit such topcoat on top of a lens surface of unknown origin, one may need the deposition of an universal adhesion layer.

The topcoat may be a complex hybrid compound, comprising for instance metallic or mineral particles or nanoparticles. It might comprise monomers or mix of monomers in order to form polymeric materials. It might even comprise active compounds such as dyes, photochromic dyes, electrochromic materials, liquid crystals...etc.

For instance, the topcoat may be one of an antifouling composition, an anti-fog composition or a bond coat, which can be used to prepare the surface of the lenses before receiving either an antifouling composition or an anti-fog composition.

The bond coat that may be interposed between the outermost coating and the topcoat comprises at least one adhesion promoter. As mentioned above, this adhesion promoter comprises, and preferably consists in, (i) a -SiXYZ head group, wherein X, Y and Z are independently chosen from an halogen atom or an - OR group wherein each R is independently a linear alkyl having from 1 to 6 carbon atoms or a branched alkyl having from 3 to 6 carbon atoms, (ii) a reactive end group which is able to react, optionally after a physical, chemical or physic-chemical treatment, with at least one function carried by at least one compound included in a topcoat composition, and (iii) a spacer that links the head and end groups.

The reactive end group is preferably any of the following groups: amino, hydroxyl, thiohydroxy, acetamido, halogeno, halogenosilane, alcoxysilane, acetoxysilane, epoxy, thioepoxy, aldehyde, alkyne, carboxyl or a group which may be converted into one of those by chemical reaction, for instance an ether, thioether, alkene, ketone or carboxylic acid ester group.

The adhesion promoter is preferably such that at least one, and preferably all, the following conditions are satisfied:
- the -SiXYZ head group is chosen from mono-, di- and tri-alcoxy silane groups, preferably tri-alcoxysilane groups, and the alcoxy group is chosen from methoxy and ethoxy groups;
- the spacer is a linear alkylene chain having from 1 to 10 carbon atoms or a branched alkylene chain having from 3 to 10 carbon atoms, wherein up to 3 carbon atoms may be substituted by an oxygen atom or a sulphur atom, preferably a linear alkylene chain having from 2 to 4 carbon atoms; and
- the reactive end group is chosen from the group consisting of amino, hydroxyl, thiohydroxy, acetamido, halogeno, halogenosilane, alcoxysilane, acetoxysilane, epoxy, thioepoxy, aldehyde, alkyne, carboxyl, ether, thioether, alkene, ketone and carboxylic acid ester groups, preferably amino or epoxy groups.

The adhesion promoter may have a molecular weight between 150 and 1000 g/mol and preferably between 165 and 450 g/mol.

Examples of adhesion promoters are 3-amino-propyltrimethoxysilane (APTMS), 3-aminopropyltriethoxysilane (APTES), 3-aminopropyl-tris(methoxyethoxyethoxy) silane, acetamido propyltrimethoxysilane, γ-glycidoxypropyl trimethoxysilane (GLYMO), γ-glycidoxypropyltriethoxysilane, and mixtures thereof.

The bond coat usually consists in the adhesion promoter, and does not contain any other compound besides the impurities optionally present in the adhesion promoter as a result of its synthesis.

The bond coat generally has a thickness ranging from 1 nm to 100 nm.

The bond coat composition may be applied onto the outermost organic coating by vacuum evaporation or by spray deposition. Various evaporation devices can be used in accordance with the process of the invention, such as devices based on ion or electron beam heating methods, devices based on highfrequency heating method, devices based on optical heating method (for example such device comprising a tungsten lamp), a Joule effect device or resistance heating device, and more generally any heating device which provides sufficient heat to evaporate the liquid coating material. Those devices are well known in the art.

The anti-fouling top coats preferably used in this invention are those which reduce surface energy of the optical article to less than 14 mJ/m². The invention has a particular interest when using anti-fouling topcoats having a surface energy of less than 13 mJ/m² and even better less than 12 mJ/m². These surface energy values are calculated according to Owens Wendt method described in the following document: Owens, D. K.; Wendt, R. G. "Estimation of the surface force energy of polymers", J. Appl. Polym. Sci. 1969, 51, 1741-1747.

The anti-fouling top coat according to the invention is preferably of organic nature. By organic nature, it is meant a layer which is comprised of at least 40% by weight, preferably at least 50% by weight of organic materials, relative to the total weight of the coating layer. A preferred anti-fouling top coat is made from a liquid coating material comprising at least one fluorinated compound, bearing in particular perfluorocarbon or perfluoropolyether group(s). By way of example, silazane, polysilazane or silicone compounds are to be mentioned, comprising one or more fluorine-containing groups such as those mentioned here above. Such compounds have been widely disclosed in the previous art, for example in Patents US 4 410 563, EP 0 203 730, EP 0 749 021, EP 0 844 265 and EP 0 933 377.

Preferred fluorinated compounds are silanes and silazanes bearing at least one group selected from fluorinated hydrocarcarbons, perfluorocarbons, fluorinated polyethers such as F₃C-(OC₃F₆)₂₄-O-(CF₂)₂-(CH₂)₂-O-CH₂-Si(OCH₃)₃ and perfluoropolyethers, in particular perfluoropolyethers.

Among fluorosilanes there may be cited the compounds of formulae: 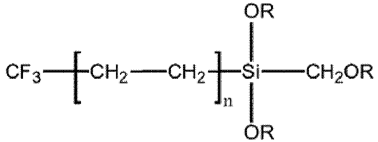 wherein n = 5, 7, 9 or 11 and R is an alkyl group, typically a C₁-C₁₀ alkyl group such as methyl, ethyl and propyl; CF₃CH₂CH₂ SiCl3; CF₃-CF₂-(CH₂CH₂)_{n'}-SiCl3 ; and 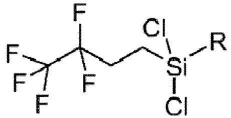 wherein n' = 7 or 9 and R is as defined above.

Compositions containing fluorinated compounds also useful for making hydrophobic and/or oleophobic top coats are disclosed in US 6,183,872. The silicon- containing organic fluoropolymer of US 6,183,872 is represented by the below general formula and has a number average molecular weight of from 5.10² to 1.105.

The predetermined liquid coating composition to be deposited may be any liquid solution. In some cases, it is useful to provide the needed compounds in a solvent: for instance water, or ethanol, or methanol, or HFE7100 or other solvents.

The predetermined liquid coating composition has for instance a concentration of compound into the solvent which might vary from 0,1% up till 100%.

The predetermined liquid coating composition has a concentration of compound vs. solvent which depend on the viscosity of solvent and compound and/or of the vaporization pressure at ambient temperature of the solvent.

The viscosity of the predetermined liquid coating composition to be evaporated might depend on the solvent used if any.

The necessary volume of predetermined coating composition may vary depending on the final thickness of material needed, the concentration of material in the solution, the concentration of compound in the solution.

In a variant that is not illustrated, the article holder and the hollow housing are not formed as a single piece, and the hollow housing is distinct to the article holder. In other words, the article holder is not formed by a protuberance provided in the body of the hollow housing, as described above. For instance, the hollow housing is dome-shaped and is mounted on the second support; while the article holder is a plate located in the housing space and maintained in position therein thanks to a dedicated support of the machine or thanks to a supporting member formed in the hollow housing.

In other variants that are not illustrated:
- the hollow housing comprises one or a plurality of inlet openings and/or further comprises one or a plurality outlet openings;
- the crucible is located in a geometrical plane and the inlet opening of the housing space is formed the same geometrical plane, or the housing space recovers at least partially the crucible, or in other words, the crucible is at least partially inside the housing space;
- the control unit of the machine is configured to control the evaporation device for depositing an adhesion coating and/or a topcoat on the optical article;
- the vacuum valve is not used to causing the vacuum pump to suck or not to suck gases from the vacuum chamber, but rather the control unit is configured to directly put on and put off the vacuum pump (flow connection and flow interruption);
- the first and second supports are not disposed on the door of the vacuum chamber, but rather directly in the vacuum chamber and the evaporation device, in particular the heating module, is thus not disposed on the door but also in the vacuum chamber;
- the first support and/or the second support are vertically movable and configured to select the vertical distance between the hollow housing and the crucible;
- the filtering device is not disposed after the vacuum pump, but rather between the vacuum pump and the vacuum chamber;
- the crucible is not formed as a porous member which is imbibed with the predetermined liquid coating composition, but rather as a receptacle into which the liquid coating composition is poured;
- the pressure sensor is not connected to the outlet circuit via a branching point, but rather the pressure sensor is directly connected to the vacuum chamber; and/or
- the values of pressure, temperature and time are different, for instance the evaporation treatment pressure is about 1 to 1000 mbar rather than 50 mbar and the heating temperature is about 200 to 500 °C rather than 350 °C.

It should be noted more generally that the invention is not limited to the examples described and represented.

## Claims

1. Machine for coating an optical article (28), comprising:
- a vacuum chamber (8) having an interior space (31) configured to receive said optical article; and
- an evaporation device (10) configured to carry out a vacuum evaporation treatment of a coating composition for depositing the coating composition onto said optical article in said interior space, said evaporation device comprising in the interior space a crucible (30) from which the coating composition in evaporated state leaves the evaporation device;
**characterized in that** the machine (1) comprises in the interior space a hollow housing (40) surrounding a housing space (41) which is at least partially above the crucible and open towards the crucible, and the machine comprises in the housing space an article holder (42), the hollow housing and the article holder being configured for locating in the housing space the optical article held by the article holder.

2. Machine according to claim 1, in which the vertical distance between the crucible (30) and the article holder (42) is between 2 and 20 times smaller than the height of the interior space (31); and/or preferably, the vertical distance between the crucible and the article holder is between 10 mm and 200 mm.

3. Machine according to one of claims 1 and 2, in which the hollow housing (40) is dome-shaped.

4. Machine according to any of claims 1 to 3, in which the hollow housing (40) is duct-shaped with at least one inlet opening (50) and at least one outlet opening (52), the inlet opening facing the crucible (30), the article holder (42) being located between the inlet opening and the outlet opening.

5. Machine according to claim 4, in which the at least one inlet opening (50) has an apparent section (51) and is positioned so that the apparent section covers a part of an evaporation cone (68) formed by the coating composition in evaporated state when leaving the crucible (30).

6. Machine according to one of claims 4 and 5, in which the outlet opening (52) faces away from the crucible (30); and/or the hollow housing (40) has a plurality of said outlet openings.

7. Machine according to any of claims 1 to 6, in which the hollow housing (40) comprises two main surfaces (46, 47) facing each other and the article holder (42) is configured for locating the optical article (28) held by the article holder with each main face of the optical article facing a respective one of said main surfaces; and optionally, the article holder (42) is configured for locating the optical article held by the article holder at mid-distance between the two main surfaces.

8. Machine according to claim 7, in which the main surfaces (46, 47) are substantially parallel one another; and/or one of said main surfaces belongs to a removable wall (44).

9. Machine according to one of claims 7 and 8, in which the hollow housing (40) comprises two transverse surfaces (48) facing each other and each extending from one of the main surfaces (46) to the other of the main surfaces (47), the housing space (41) being delimited laterally by the main surfaces and by the transverse surfaces.

10. Machine according to claim 9, in which the transverse surfaces (48) are arranged as mirror images of each other.

11. Machine according to any one of claims 7 to 10, in which the housing space (41) has a divergent portion (56) between an inlet opening (50) and an optical article receiving portion (57).

12. Machine according to any of claims 7 to 11, further comprising in the housing space (41) a flow separator (61) and wherein the hollow housing (40), the article holder (42) and the flow separator are configured for receiving two lenses (32) in respective predetermined locations in the housing space (41) with the flow separator (61) disposed between the respective predetermined locations; and optionally, the flow separator (61) extends below the respective predetermined locations.

13. Machine according to claim 12, in which the article holder (42) and the flow separator (61) are formed by a protuberance (60) extending transversely between the main surfaces (46, 47).

14. Machine according to any one of claims 1 to 13, in which the housing space (41) is configured for only receiving a small number of optical articles (28) to be coated, for instance two or even one article; and/or preferably the housing space has a volume between 2 and 20 times smaller than the volume of the interior space; and/or preferably the housing space has a volume between 300 and 600 cm³.

15. Machine according to any one of claims 1 to 14, in which the article holder (42) is configured for holding a pair of glasses comprising a frame (31) and two lenses (32).

16. An assembly comprising a machine according to any one of claims 1 to 15 and an optical article (28) held by the article holder (42) of said machine (1); and preferably in which the optical article is a pair of glasses comprising a frame (31) and two lenses (32).

17. Method for coating an optical article comprising the step of providing a machine (1) according to any one of claims 1 to 15, the step of holding the optical article (28) with the article holder (42) in the housing space (41) and the step of carrying out with said machine a coating composition depositing cycle.
